Europäisches Patentamt

European Patent Office

Office européen des brevets

(19)

(11) Veröffentlichungsnummer: **0 071 129**
**A2**

(12) # EUROPÄISCHE PATENTANMELDUNG

(21) Anmeldenummer: **82106451.6**

(22) Anmeldetag: **17.07.82**

(51) Int. Cl.³: **G 03 G 15/00**
**F 26 B 15/14**

(30) Priorität: **29.07.81 DE 8122197 U**

(43) Veröffentlichungstag der Anmeldung:
**09.02.83 Patentblatt 83/6**

(84) Benannte Vertragsstaaten:
**AT BE CH DE FR GB IT LI NL**

(71) Anmelder: **HOECHST AKTIENGESELLSCHAFT**
**Postfach 80 03 20**
**D-6230 Frankfurt/Main 80(DE)**

(72) Erfinder: **Britzke, Sylvia**
**Eintrachtstrasse 13**
**D-6200 Wiesbaden(DE)**

(72) Erfinder: **Heist, Hans**
**Frankenwaldstrasse 7**
**D-6200 Wiesbaden-Delkenheim(DE)**

(72) Erfinder: **Töpfer, Dieter**
**Mühlweg 5**
**D-6209 Heidenrod 3(DE)**

(54) **Trockenvorrichtung für Druckplatten.**

(57) Die Erfindung betrifft eine Trockenstation 17 für Druckplatten 3, in der oberhalb der Durchlaufebene der Druckplatten Lüfter 18 schräg angeordnet sind. Die in Richtung A laufenden Druckplatten werden von Auslaufwalzen 4,5 durch einen Austrittsspalt 6 in einer Bearbeitungsstation 1, die über Flansche 9, 10 mit der Trockenstation 17 verbunden ist, durch einen Eintrittsspalt 19 in die Trockenstation 17 eingeschoben. Dort gelangen die Druckplatten auf ein horizontales Blech 20, das auf Querstreben 22, 23 aufliegt. Den Lüftern 18 sind Heizregister 15, 16 vorgeschaltet, die den Luftstrom 21 erwärmen. Auslaufwalzen 24, 25 transportieren die Druckplatte nach dem Verlassen eines Ausgabespalts 26 auf eine schräge Ablaufplatte 14, die auf einer Unterlage 13 aufliegt.

./...

FIG. 2

HOECHST AKTIENGESELLSCHAFT
KALLE Niederlassung der Hoechst AG

Hoe 81/K 043                - 1 -                16. Juli 1982
                                                WLK-DI.Z.-is

Trockenvorrichtung für Druckplatten

Die Erfindung betrifft eine Trockenvorrichtung für Druckplatten, mit Lüftern oberhalb der Durchlaufebene der
Druckplatten.

In Verarbeitungsanlagen für Druckplatten, die mehrere Bearbeitungsstationen umfassen, wird die einzelne Druckplatte elektrostatisch aufgeladen, mit dem Bild einer
Vorlage belichtet, anschließend entwickelt, fixiert, entschichtet, gummiert und zuletzt getrocknet. Dabei ist
darauf zu achten, daß die Druckplatte die letzte Bearbeitungsstation, in der die Gummierung der Druckplatte erfolgt, trocken verläßt.

Bei einer in der Praxis eingesetzten Trockenstation erfolgt die Trocknung der Druckplatte nach dem Verlassen
der Gummierstation durch einen Luftstrom, der von einem
oder mehreren Lüftern auf die Oberfläche der Druckplatte
geblasen wird. Diese Lüfter, es handelt sich hierbei um
Tangentiallüfter, sind an die Außenseite der Gummierstation des Verarbeitungssystems für Druckplatten angehängt. Die aus der Gummierstation austretende Druckplatte gelangt auf eine zur Horizontalen geneigte Ablaufplatte. Unmittelbar vor dem Austrittsspalt der Gummierstation ist ein Auslaufwalzenpaar angeordnet, in dessen
Spalt sich im allgemeinen ein Flüssigkeitskeil durch die
abgequetschte Gummierung bildet. Dieser Flüssigkeitskeil
bewirkt, daß sich vor allem auf der Unterseite der Druck-

HOECHST AKTIENGESELLSCHAFT
KALLE Niederlassung der Hoechst AG

- 2 -

platte im Bereich der Plattenhinterkante ein feuchtklebriger Gummierstreifen ausbildet. Wird die Druckplatte nach dem Verlassen der Gummierstation nur auf der Oberseite mit Luft beaufschlagt, so bleibt der feuchtklebrige Gummierstreifen auf der Unterseite erhalten, wodurch bei einer Stapelung der fertigen Druckplatten es zum Verkleben der Platten im Stapel kommt. Nachteilig ist auch bei der bekannten Trockenstation, daß die Druckplatte nach dem Verlassen der Gummierstation nicht mehr durch Walzen geführt wird, wodurch ihre Transportgeschwindigkeit ungleichmäßig und ihre Verweilzeit im Luftstrom der Lüfter zu kurz ist, um eine einwandfreie Trocknung der Druckplatte zu ermöglichen.

Aufgabe der Erfindung ist es, eine Trockenvorrichtung für Druckplatten zu schaffen, mit der eine vollständige, einwandfreie Trocknung der Druckplatten, nicht nur auf der Ober-, sondern auch auf der Unterseite der Druckplatte, soweit diese mit der Beschichtung oder Gummierung in Berührung gekommen ist, ermöglicht wird.

Diese Aufgabe wird durch die Erfindung in der Weise gelöst, daß ein Blech mit nicht glatter Oberfläche als horizontale Plattenführung in der Trockenvorrichtung vorgesehen ist, daß die Lüfter geneigt zu dem Blech angeordnet sind und daß in Transportrichtung nach den Lüftern Auslaufwalzen mit ihrem Spalt auf der Höhe des Blechs und nahe zu einem Ausgabespalt liegen und die Druckplatte in Transportrichtung über das Blech mit gleichmäßiger Geschwindigkeit und kontinuierlich befördern.

HOECHST AKTIENGESELLSCHAFT
KALLE Niederlassung der Hoechst AG

- 3 -

In zweckmäßiger Ausgestaltung der Erfindung ist das Blech ein Rautenblech, dessen Querschnitt wellenförmig ausgebildet ist. Dabei sind die erhabenen Prägungen des Rautenblechs nach oben gerichtet. Dadurch wird erreicht, daß die Unterseite der Druckplatte nur jeweils punktförmig auf dem Rautenblech aufliegt, so daß vor allem im Bereich der Hinterkante der Druckplatte die Unterseite mit Warmluft angeblasen werden kann, um so vorhandene feuchtklebrige Streifen abzutrocknen.

In zweckmäßiger Ausgestaltung der Erfindung sind die Lüfter unter 45° zur Durchlaufebene der Druckplatten geneigt. Diese Ausgestaltung trägt gleichfalls dazu bei, daß während des Transportes der Druckplatte durch den unter 45° zur Oberfläche der Druckplatte geneigten Warmluftstrom die angeblasene Luft die Rückseite im Bereich der Druckplattenhinterkante bestreichen und abtrocknen kann.

Vor den Lüftern sind vorteilhafterweise Heizregister angebaut, die den von den Gebläsen der Lüfter kommenden, auf die Druckplattenoberfläche gerichteten Luftstrom erwärmen. Durch die Erwärmung des Luftstromes wird die Trocknungszeit erheblich verkürzt.

Mit der Erfindung wird der Vorteil erzielt, daß die Unterseite der Druckplatte im Bereich der Hinterkante von dem Warmluftstrom überstrichen wird und daß die Druckplatte mit derselben gleichmäßigen Verarbeitungsgeschwindigkeit, mit der sie durch die übrigen Stationen der Verarbei-

0071129

HOECHST AKTIENGESELLSCHAFT
KALLE Niederlassung der Hoechst AG

- 4 -

tungsanlage transportiert wird, an dem Warmluftstrom vorbeigeführt wird, so daß die Trocknungszeit zur einwandfreien Trocknung, auch der Unterseite der Druckplatte,
völlig ausreicht.

Die Erfindung wird im folgenden anhand der Zeichnungen
näher erläutert.

Es zeigen:

Fig. 1 eine schematische Schnittansicht einer bekannten
Trockenvorrichtung,

Fig. 2 eine schematische Schnittansicht der Trockenvorrichtung nach der Erfindung,

Fig. 3a und 3b eine Draufsicht und eine Schnittansicht
eines Bauteils der Trockenvorrichtung nach
Fig. 2.

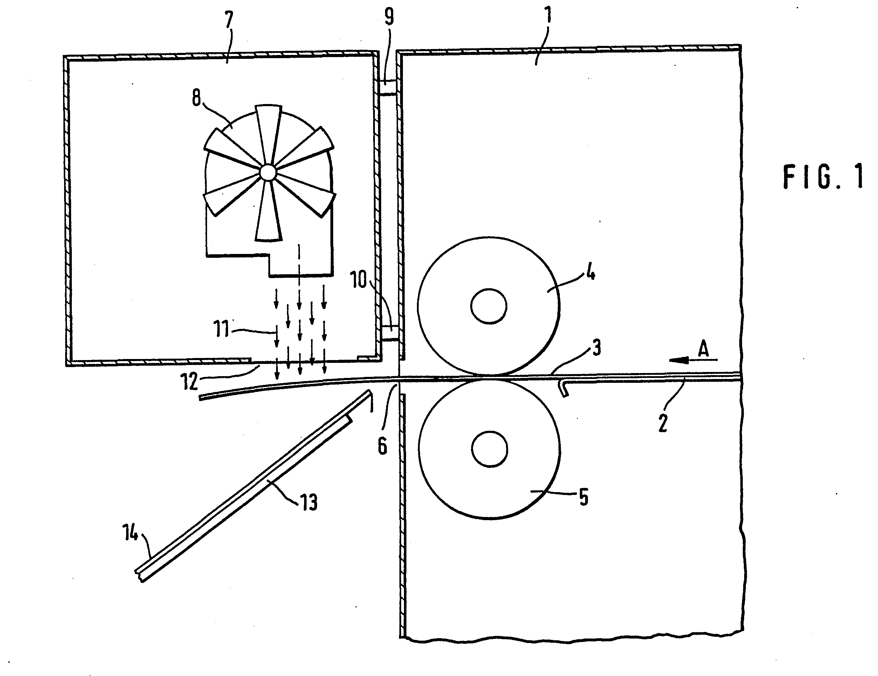

In Fig. 1 ist eine bekannte Trockenstation 7 gezeigt, die
an einer Bearbeitungsstation 1 zum Gummieren von fertigentwickelten und fixierten Druckplatten mit Flanschverbindungen 9,10 oder sonstigen Verbindungen befestigt ist.
Eine gummierte oder beschichtete Druckplatte 3 wird über
einen Tisch 2 durch die Bearbeitungsstation 1 bewegt.
Nahe einem Austrittsspalt 6 der Bearbeitungsstation 1
sind Auslaufwalzen 4 und 5 angeordnet, die einen Spalt
bilden, durch den die Druckplatte 3 hindurchbewegt wird.
Die obere Auslaufwalze 4 wischt die überschüssige Gummie-

HOECHST AKTIENGESELLSCHAFT
KALLE Niederlassung der Hoechst AG

- 5 -

rung von der Oberfläche der Druckplatte 3 ab, wobei diese überschüssige Gummierung oder ein sonstiges Beschichtungsmaterial, das in der Bearbeitungsstation 1 auf die Oberfläche der Druckplatte 3 aufgebracht wird, einen Flüssigkeitskeil am Anfang des Spalts zwischen den Auslaufwalzen 4 und 5 bildet. Bedingt durch diesen Flüssigkeitskeil gelangt am Ende des Durchlaufs der Druckplatte 3 durch das Auslaufwalzenpaar 4,5 Gummierflüssigkeit im Bereich der Druckplattenhinterkante auf die Unterseite der Druckplatte 3.

In der Trockenstation 7 sind ein oder mehrere Lüfter 8 über die Breite der Trockenstation 7 angeordnet, deren Gebläse einen Luftstrom 11 senkrecht nach unten in Richtung einer Austrittsöffnung 12 der Trockenstation 7 abblasen. Die Druckplatte 3 wird einzig und allein durch die Auslaufwalzen 4 und 5 weiterbefördert und gelangt nach dem Verlassen des Austrittsspalts 6 der Bearbeitungsstation 1 auf eine schräge Ablaufplatte 14, die auf einer Unterlage 13 befestigt ist. Der Luftstrom 11 trifft im vorderen Bereich der Druckplatte 3 in etwa senkrecht auf deren Oberfläche auf. Die Druckplatte 3 senkt sich infolge ihres Eigengewichts nach dem Verlassen des Austrittsspalts 6 auf die schräge Ablaufplatte 14. Sobald die Hinterkante der Druckplatte 3 das Auslaufwalzenpaar 4 und 5 verlassen hat, erfolgt kein kontinuierlicher und gleichmäßiger Transport der Druckplatte 3, vielmehr rutscht diese dann unkontrolliert über die Ablaufplatte 14 in einen nicht dargestellten Behälter. Da die schräge Ablaufplatte 14 eine glatte Oberfläche besitzt, liegt

HOECHST AKTIENGESELLSCHAFT
KALLE Niederlassung der Hoechst AG

- 6 -

die Unterseite der Druckplatte 3 ohne Zwischenraum auf der Ablaufplatte 14 auf, so daß der Luftstrom 11 die Unterseite der Druckplatte 3 im Bereich von deren Hinterkante nicht bestreichen kann. Somit werden auch eventuelle Flüssigkeits- bzw. Gummierungsreste auf der Unterseite der Druckplatte 3 nicht abgetrocknet und bei einer Stapelung von Druckplatten kommt es zum Verkleben der Platten im Stapel.

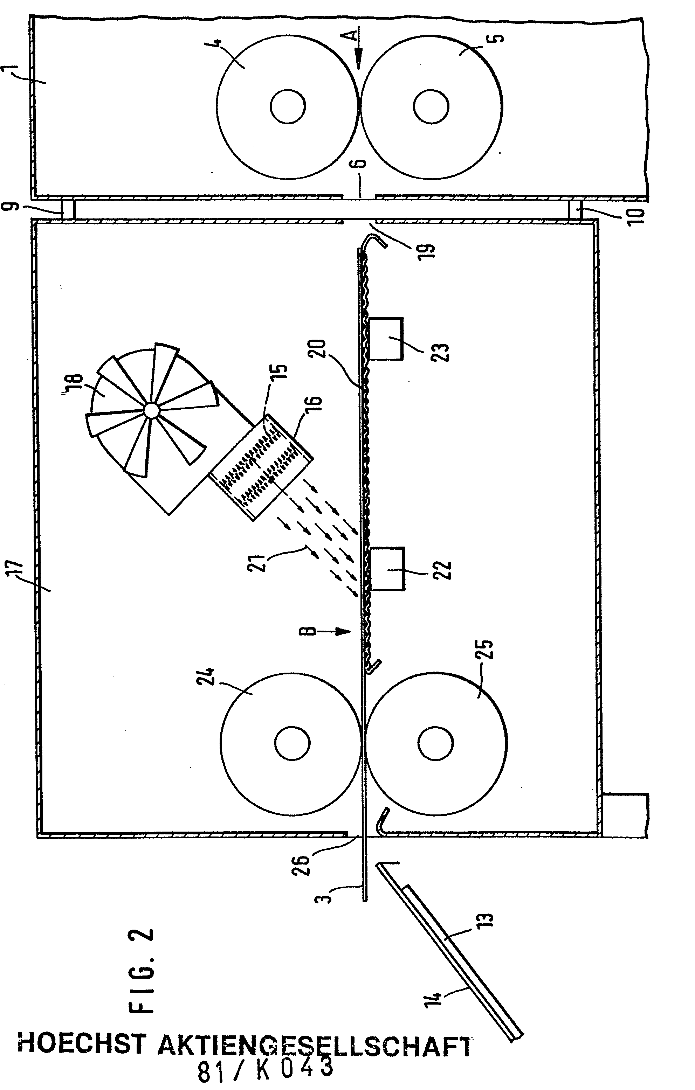

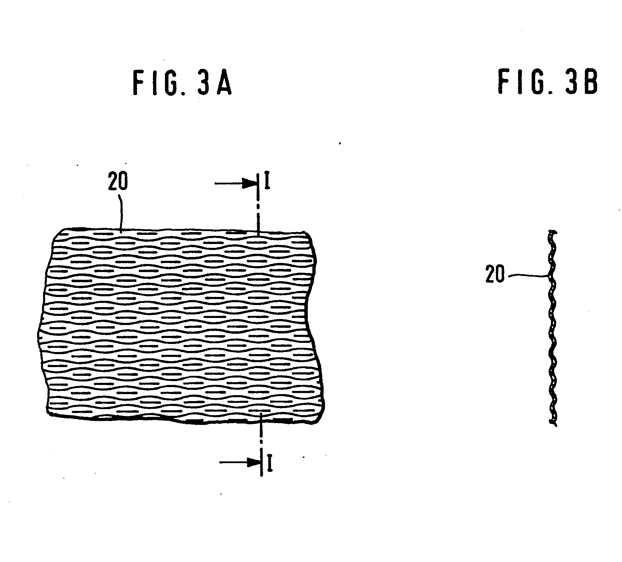

Ein derartiges Verkleben wird bei der in Fig. 2 gezeigten Trockenstation 17 nach der Erfindung vermieden. Gleiche Bauteile wie bei der in Fig. 1 gezeigten Trockenstation sind mit den gleichen Bezugzahlen wie in Fig. 1 belegt. Die Trockenstation 17 ist wieder mit Flanschverbindungen 9 und 10 an der Bearbeitungsstation 1 befestigt. Die in Transportrichtung A bewegte Druckplatte 3 wird durch den Spalt zwischen den Auslaufwalzen 4 und 5 hindurchbewegt und gelangt durch den Austrittsspalt 6 auf ein horizontal angeordnetes Blech in der Trockenstation 17. Das Blech 20 besitzt eine nicht glatte Oberfläche und ist beispielsweise ein Rautenblech, dessen erhabene Prägungen nach oben gerichtet sind. Eine Draufsicht auf das Rautenblech 20 in Richtung des Pfeils B ist in Fig. 3a dargestellt. Einen Querschnitt längs der Linie I-I durch das Rautenblech zeigt Fig. 3b, aus der hervorgeht, daß das Blech 20 wellenförmig ausgebildet ist. Es ist selbstverständlich auch möglich, andere gewellte Bleche oder geprägte Bleche anstelle eines Rautenblechs zu verwenden. Es muß dabei nur sichergestellt sein, daß die Unterseite der Druckplatte 3 auf dem Blech 20 an vielen Stellen punktförmig aufliegt. Es ist auch möglich, anstelle der zuvor beschriebenen Bleche ein Blech zu verwenden, das beispielsweise in Transportrichtung zwei oder mehrere Längsstege aufweist, die keine zusammenhängende Linie bilden, sondern vielmehr aus kurzen, hintereinander angeordneten Stücken bestehen. Das Blech 20 liegt auf Querstreben 22,23 als Auflagestützen auf. Oberhalb des Bleches 20 sind ein oder mehrere Lüfter 18, beispielsweise Tangentiallüfter, angeordnet, von denen in Fig. 1 nur einer sichtbar ist. Die Lüfter 18 sind nebeneinander über die Breite der Trockenstation 17 angebracht. Jedem Lüfter 18 sind Heizregister 15 und 16 vorgeschaltet, die den von den Gebläsen der Lüfter 18 erzeugten Luftstrom erwärmen. Die Lüfter 18 sind gegenüber der Ebene der Plattenführung, d.h. gegenüber dem Blech 20, bevorzugt um 45° geneigt, so daß der Warmluftstrom 21 unter diesem Winkel auf die Oberfläche der Druckplatte 3 auftrifft.

In der Trockenstation 17 ist in Transportrichtung A nach dem Blech 20 ein Auslaufwalzenpaar 24,25 angeordnet. Dieses stellt sicher, daß die Druckplatte 3 gleichmäßig und kontinuierlich mit derselben Verarbeitungsgeschwindigkeit wie in den übrigen Bearbeitungsstationen der Druckplattenverarbeitungsanlage über das Blech 20 transportiert wird. Die Druckplatte 3 tritt aus einem Ausgabespalt 26 der Trockenstation 17 aus und gelangt auf die schräge Ablaufplatte 14, die auf der Unterlage 13 aufliegt. Durch die Verwendung eines Rautenbleches oder eines sonstigen Bleches mit erhabenen Prägungen, die nach oben zeigen, für die Plattenführung wird sichergestellt, daß die

HOECHST AKTIENGESELLSCHAFT
KALLE Niederlassung der Hoechst AG

- 8 -

Unterseite der Druckplatte 3 im Prinzip nur punktförmig auf dem Blech 20 aufliegt. Dadurch ist es möglich, daß der unter einem Winkel von 45° zur Durchlaufebene auf die Oberfläche der Druckplatte 3 auftreffende Warmluftstrom 21 neben der Oberseite auch die Unterseite der Druckplatte 3 im Bereich der Hinterkante bestreicht und abtrocknet. Da die Druckplatte 3 durch das Auslaufwalzenpaar 24 und 25 gleichmäßig und kontinuierlich durch die Trockenstation 17 befördert wird, ist ausreichend Zeit für das Abtrocknen der Unterseite im Hinterkantenbereich der Druckplatte 3 gegeben. Es ist selbstverständlich, daß die Neigung der Lüfter 18 zu der Durchlaufebene der Platte 3 auch einen anderen Winkel als 45° einnehmen kann.

---

HOECHST AKTIENGESELLSCHAFT
KALLE Niederlassung der Hoechst AG

Hoe 81/K 043                    - 9 -                    16. Juli 1982
                                                        WLK-DI.Z.-is

## Patentansprüche

1. Trockenvorrichtung für Druckplatten mit Lüftern oberhalb der Durchlaufebene der Druckplatten, dadurch gekennzeichnet, daß ein Blech (20) mit nicht glatter Oberfläche als horizontale Plattenführung in der Trockenvorrichtung (17) vorgesehen ist, daß die Lüfter (18) geneigt zu dem Blech (20) angeordnet sind und daß in Transportrichtung (A) nach den Lüftern (18) Auslaufwalzen (24,25) mit ihrem Spalt auf der Höhe des Blechs (20) und nahe zu einem Ausgabespalt (26) liegen und die Druckplatte (3) in Transportrichtung (A) über das Blech (20) mit gleichmäßiger Geschwindigkeit und kontinuierlich befördern.

2. Trockenvorrichtung nach Anspruch 1, dadurch gekennzeichnet, daß das Blech (20) ein Rautenblech ist, dessen Querschnitt wellenförmig ausgebildet ist.

3. Trockenvorrichtung nach Anspruch 2, dadurch gekennzeichnet, daß die erhabenen Prägungen des Rautenblechs nach oben gerichtet sind.

4. Trockenvorrichtung nach Anspruch 1, dadurch gekennzeichnet, daß die Lüfter (18) unter 45° zur Durchlaufebene der Druckplatten (3) geneigt sind.

5. Trockenvorrichtung nach Anspruch 1, dadurch gekennzeichnet, daß vor den Lüftern (18) Heizregister (15,16)

HOECHST AKTIENGESELLSCHAFT
KALLE Niederlassung der Hoechst AG

- 10 -

angebaut sind, die den von den Gebläsen der Lüfter (18) kommenden, auf die Druckplattenoberfläche gerichteten Luftstrom erwärmen.

---

FIG. 1

HOECHST AKTIENGESELLSCHAFT 81/K 043

0071129

# FIG. 3A

# FIG. 3B

HOECHST AKTIENGESELLSCHAFT
81 / K 043